**Europäisches Patentamt**

**European Patent Office**

**Office européen des brevets**

(11) Veröffentlichungsnummer: **0 406 756 A2**

# EUROPÄISCHE PATENTANMELDUNG

(21) Anmeldenummer: **90112580.7**

(22) Anmeldetag: **02.07.90**

(51) Int. Cl.5: **G06F 15/60**

(30) Priorität: **05.07.89 DE 3922022**

(43) Veröffentlichungstag der Anmeldung:
**09.01.91 Patentblatt 91/02**

(84) Benannte Vertragsstaaten:
**DE FR GB**

(71) Anmelder: **Bodenseewerk Gerätetechnik GmbH**
**Alte Nussdorfer Strasse 15 Postfach 1120**
**D-7770 Überlingen/Bodensee(DE)**

(72) Erfinder: **Gaus, Martin, Dipl.-Ing.**
**Auf dem Berg 21**
**D-7772 Uhldingen-Mühlofen(DE)**
Erfinder: **Ruckert, Udo, Dr.**
**Höriweg 3**
**D-7772 Uhldingen 1(DE)**

(74) Vertreter: **Weisse, Jürgen, Dipl.-Phys. et al**
**Patentanwälte Dipl.-Phys. Jürgen Weisse**
**Dipl.-Chem. Dr. Rudolf Wolgast Bökenbusch**
**41 Postfach 11 03 86**
**D-5620 Velbert 11 Langenberg(DE)**

(54) Verfahren zur Simulation eines elektrischen Systems bei der rechnergeschützten Entwicklung elektrischer Systeme.

(57) Bei einem Verfahren zur Simulation eines elektrischen Systems bei der bei der rechnerunterstützten Entwicklung elektrischer Systeme wird eine Baugruppe des Systems durch ein Software-Modell simuliert. Das Software-Modell wird durch Stimuli angeregt. Das Verhalten des Software-Modells wird anhand von Ausgangsdaten beobachtet. Die Stimuli werden in Abhängigkeit von zuvor erzeugten Ausgangsdaten in einer die logischen und zeitlichen Relationen der Baugruppe zu ihrer Umgebung wiederspiegelnden Weise erzeugt.

## TECHNISCHES GEBIET

Die Erfindung betrifft ein Verfahren zur Simulation eines elektrischen Systems bei der bei der rechnerunterstützten Entwicklung elektrischer Systeme, bei welchem

(a) eine Baugruppe des Systems durch ein Software-Modell simuliert wird,

(b) das Software-Modell durch Stimuli angeregt wird und

(c) das Verhalten des Software-Modells anhand von Ausgangsdaten beobachtet wird.

### Zugrundeliegender Stand der Technik

Durch den Einsatz rechnerunterstützter Entwicklungsmethoden für elektrische Schaltungen ist es möglich geworden, Fehlfunktionen einer Konstruktion in einem sehr frühen Stadium des fntwicklungsablaufs festzustellen und zu beseitigen.

Nach dem Stand der Technik geschieht das in der weise, daß zunächst ein Software-Modell einer zu entwerfenden Hardware-Baugruppe hergestellt wird. Diese Simulation der Hardware-Eigenschaften der Baugruppe setzt voraus, daß das Verhalten aller Teilkomponenten der Baugruppe bekannt und in einer für den Simulator verständlichen Art beschrieben sind.

Das Software-Modell der Baugruppe wird dann durch "Stimuli" angeregt, die vom Entwickler vorgegeben werden. Diese Stimuli bilden Vektoren von Eingangsdaten, die dem Software-Modell der Baugruppe zugeführt werden. Es werden dann die durch die Stimuli erzeugten Ausgangsdaten beobachtet. Nach dem Stand der Technik sind die einzelnen Schritte dieser Anregung zeitlich fest vorgegeben. Diese Schritte werden im Laufe der Simulation weder in ihrem Inhalt noch in ihrem Zeitablauf verändert.

Auf diese weise wird die entworfene Baugruppe "verifiziert". Das funktioniert bei Systemen, die ohne weitere Wechselwirkung mit der Umgebung einfach Eingabedaten in Ausgabedaten umwandeln. Diese Art der Verifizierung ist jedoch häufig nicht anwendbar, wenn es darum geht, eine fehlerfreie Funktion auch bei der Integration der Baugruppe in ein übergeordnetes mit Wechselwirkungen behaftetes System zu gewährleisten. Der Einfluß der elektrischen Umgebung der Baugruppe kann nur unzulänglich in festen Stimuli beschrieben werden und kann daher nur mit erheblicher Unsicherheit verifiziert werden. In der Regel kommuniziert eine Baugruppe mit seiner elektrischen Umgebung bidirektional: Die Umgebung der Baugruppe macht seine weiteren Aktionen abhhängig von den Reaktionen der Baugruppe. Dieser Kommunikationsfluß über die Schnittstelle "System - Systemumgebung" kann mit den bekannten Methoden nur unzulänglich nachvollzogen werden. Daher kann dieser Kommunikationsfluß auch nur unzulänglich verifiziert werden. Das stellt eine Fehlerquelle dar, die erst bei der späteren Integration der dann als Hardware realisierten Baugruppe in ein Gesamtsystem feststellbar wird.

### Offenbarung der Erfindung

Der Erfindung liegt die Aufgabe zugrunde, bei der Verifikation von als Software-Modelle dargestellten Baugruppen die elektrische Umwelt der Baugruppe mit Hilfe von Hardwarebeschreibungsmethoden in die Verifikation mit einzubeziehen.

Erfindungsgemäß wird diese Aufgabe dadurch gelöst, daß

(d) die Stimuli in Abhängigkeit von zuvor erzeugten Ausgangsdaten in einer die logischen und zeitlichen Relationen der Baugruppe zu ihrer Umgebung wiederspiegelnden Weise erzeugt werden.

Die Anregung des zu verifizierenden Systems wird somit in Abhängigkeit von zuvor erzeugten Ausgangsdaten durchgeführt. Diese Abhängigkeit der Stimuli von den Ausgangsdaten kann beliebig komplex sein. Sie muß die logischen wie auch zeitlichen Relationen zur Umgebung der Baugruppe zu ihrer Umgebung wiederspiegeln. Mit Hilfe geeigneter Beschreibungssprachen können diese Relationen auf relativ abstrakte Art spezifiziert werden. Im Gegensatz zu dem oben diskutierten bekannten Verfahren weist diese Methode alle Merkmale einer Regelstruktur auf: Dem Regler entspricht die Umgebung, der Regelstrecke entspricht die zu verifizierende Baugruppe und der Beobachtungseinrichtung entsprechen die bei der Simulation erhaltenen Ausgangsdaten. Die Erzeugung von Stimuli in Abhängigkeit von den Ausgangsdaten stellt somit ein Modell der elektrischen Umgebung dar. Das ist ein wesentlicher Schritt zur Beseitigung von Fehlerquellen, die bei einem Vorgehen nach dem Stand der Technik erst bei der Integration der realisierten Baugruppe in das Gesamtsystem erkennbar wären.

Ein Ausführungsbeispiel der Erfindung ist nachstehend unter Bezugnahme auf die zugehörigen Zeichnungen näher erläutert.

### Kurze Beschreibung der Zeichnungen

Fig.1 veranschaulicht schematisch das Verfahren nach dem Stand der Technik.

Fig.2 veranschaulicht in entsprechender Darstellung das Verfahren mit Wahl der Stimuli in Abhängigkeit von den Ausgangsdaten.

Fig.3 zeigt schematisch den Aufbau eines VME-Bus Systems als Beispiel für die Anwendung des Verfahrens nach Fig.2.

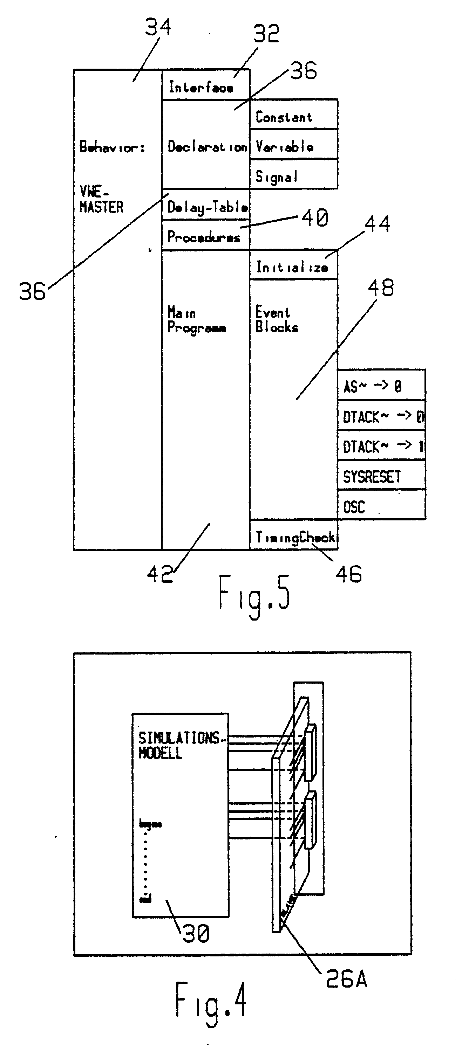

Fig .4 zeigt schematisch die Schnittstelle zwischen simulierter Umgebung und dem zu verifizierenden Baugruppe "Slave" des VME-Bus Systems, wobei die Baugruppe in Fig.4 als Hardware dargestellt ist, tatsächlich aber durch ein Software-Modell repräsentiert wird.

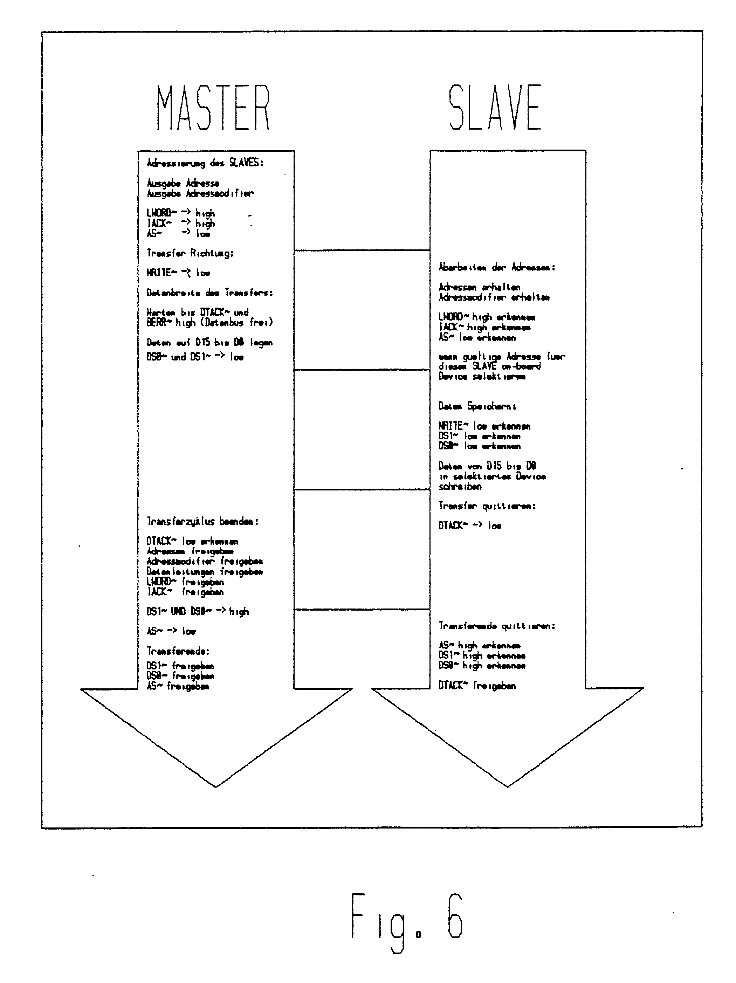

Fig.5 zeigt schematisch den Aufbau des Modells der Umgebung "Master" des VME-Bus Systems.

Fig.6 veranschaulicht die Kommunikation zwischen "Master" (Umgebung) und "Slave" (zu verifizierendem Bauteil) eine VME-Bus Systems.

## Darstellung des Standes der Technik

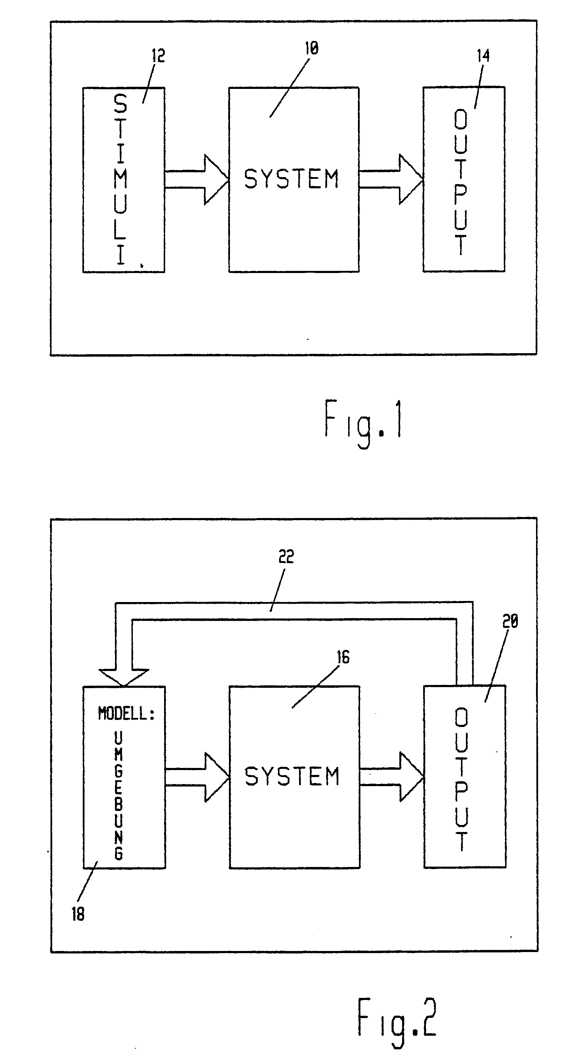

In Fig.1 ist zur besseren Verdeutlichung der Erfindung schematisch das Verfahren nach dem Stand der Technik dargestellt.

Mit 10 ist eine zu verifizierende Baugruppe bezeichnet. Diese Baugruppe wird bei der rechnerunterstützten Entwicklung durch ein Software-Modell repräsentiert. Diese Baugruppe 10 wird durch Stimuli angeregt, die von einem "Stimuligenerator" 12 erzeugt werden. Diese Stimuli sind Vektoren von Eingangsdaten, die der Baugruppe 10 zugeführt werden. Die Stimuli sind dabei nach dem Stand der Technik in ihrem Inhalt und in ihrer zeitlichen Aufeinanderfolge fest vorgegeben. Die Stimuli bewirken die Erzeugung von Ausgangsdaten durch die Baugruppe 10. Diese Ausgangsdaten sind durch einen Block 14 dargestellt. Die Ausgangsdaten werden beobachtet.

## Bevorzugte Ausführung der Erfindung

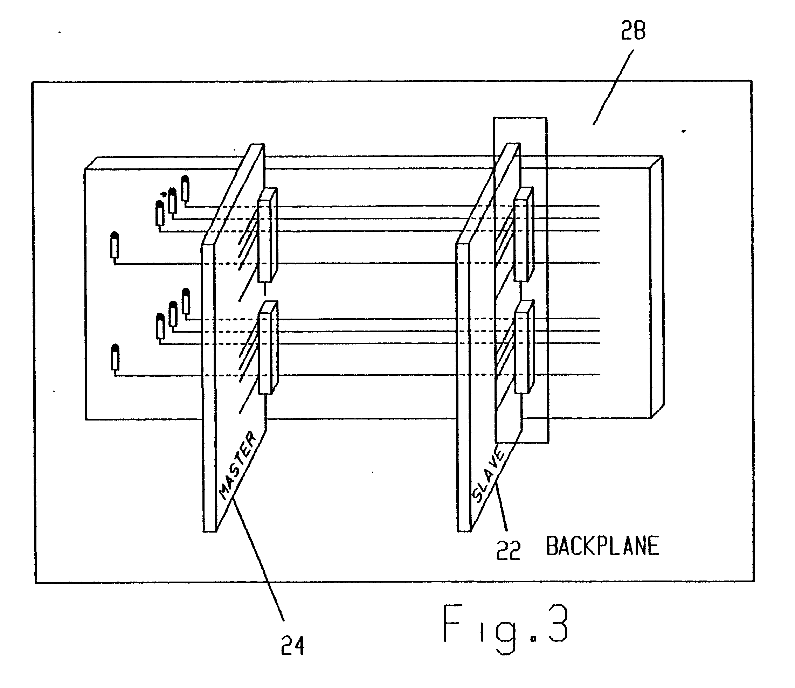

In Fig.2 ist die Baugruppe mit 16 bezeichnet. Auch hier ist die Baugruppe 16 durch ein Software-Modell repräsentiert. Die Baugruppe 16 erhält Stimuli von einem Modell 18 der elektrischen Umgebung der Baugruppe 16. Die Baugruppe 16 liefert Ausgangsdaten, die wieder durch einen Block 20 repräsentiert sind. Diese Ausgangsdaten beeinflussen jedoch das Modell 18, wie durch die Datenleitung 22 angedeutet ist, und damit auch die auf die Baugruppe 16 gegebenen Stimuli.

Fig.3 zeigt als Beispiel ein VME-Bus System. Das VME-Bus System enthält eine Baugruppe 24 "Master" und eine Baugruppe 26 "Slave". Die beiden Baugruppen 24 und 26 kommunizieren über eine gemeinsame Busplatine 28. Die Elektronik der Baugruppe 26 "Slave" soll entworfen werden. Zu diesem Zweck wird ein Software-Modell dieser Baugruppe erstellt. Dieses Software-Modell ist in Fig.4 mit 26A bezeichnet. Es ist in Fig.4 durch die entsprechende Hardware symbolisiert. Für die Baugruppe 26 existiert eine elektrische Umwelt, die für die Realisierung der Gesamtfunktion von entscheidender Bedeutung ist.

Diese elektrische Umwelt, wie sie von der Baugruppe 26 aus "gesehen" wird, enthält nicht nur die Baugruppe 24 sondern auch die Busplatine 28. Es wird daher ein Simulationsmodell erstellt, das sowohl die Funktion der Baugruppe 26 "Master" als auch die Funktion der Busplatine 28 ersetzt. Dieses Simulationsmodell ist in Fig.4 durch den Block 30.

Das Verhalten der Umwelt wird in Form einer Hardware-Beschreibungssprache (Behaviour) abgebildet. Der Aufbau dieser Beschreibung kann in Funktionsblöcke unterteilt werden, wie in Fig.5 dargestellt ist. Diese Funktionsblöcke von Fig.5 sind folgende:

Ein Interface 32 stellt die Verbindung von dem Behaviour-Modell 34 zu den angeschlossenen Signalleitungen her. Ein "Declaration"-Teil 36 dient der Vereinbarung von Konstanten, Variablen und Signalen. "Delay-Tables" 36 speichern Verzögerungszeiten der Ausgangssignale mit nominalen. minimalen und maximalen Werten für fallende und steigende Flanke in Abhängigkeit von vorangegangenen Änderungen der Eingangssignale. Ein Block 40 "Prozeduren" dient der Vereinbarung mehrfach auftretender Befehlssequenzen als Prozeduren. Ein Block 42 "Hauptprogramm" enthält die Teile 44 "Initialisieren", 46 "Zeitprüfung" und als Kernstück "Ereignisblöcke" 48. Bei der Initialisierung werden den Signalen Werte für den Start der Simulation zugewiesen. Bei der Zeitprüfung werden minimal geforderte Pulslängen und Setupzeiten überprüft. Ein "Ereignis" ist eingetreten, wenn ein relevantes Signal seinen logischen Zustand ändert. Die daraus resultierende Zuweisung neuer Werte für andere Signale lösen im allgemeinen neue Ereignisse aus.

Fig.6 veranschaulicht die typische Kommunikation zwischen den Baugruppen 24 "Master" und 26 "Slave" bei einem VME-Bus System. Die Position der auftretenden Ereignisse soll dabei die zeitliche Reihenfolge grob verdeutlichen.

## Ansprüche

Verfahren zur Simulation eines elektrischen Systems bei der bei der rechnerunterstützten Entwicklung elektrischer Systeme, bei weichem

(a) eine Baugruppe (16) des Systems durch ein Software-Modell simuliert wird,

(b) das Software-Modell durch Stimuli angeregt wird und

(c) das Verhalten des Software-Modells anhand von Ausgangsdaten (20) beobachtet wird, **dadurch gekennzeichnet, daß**

(d) die Stimuli in Abhängigkeit von zuvor erzeugten Ausgangsdaten in einer die logischen und zeitlichen Relationen der Baugruppe (16) zu ihrer Umgebung wiederspiegelnden Weise erzeugt werden.

Fig.1

Fig.2

MASTER

SLAVE

22  BACKPLANE

28

24

Fig.3

EP 0 406 756 A2

Fig.5

Fig.4

MASTER

SLAVE

Adressierung des SLAVES:

Ausgabe Adresse
Ausgabe Adressmodifier

LWORD~ -> high
IACK~ -> high
AS~ -> low

Transfer Richtung:

WRITE~ -> low

Datenbreite des Transfers:

Warten bis DTACK~ und
BERR~ high (Datenbus frei)

Daten auf D15 bis D0 legen

DS0~ und DS1~ -> low

Abarbeiten der Adressen:

Adressen erhalten
Adressmodifier erhalten

LWORD~ high erkennen
IACK~ high erkennen
AS~ low erkennen

wenn gueltige Adresse fuer
diesen SLAVE on-board
Device selektieren

Daten Speichern:

WRITE~ low erkennen
DS1~ low erkennen
DS0~ low erkennen

Daten von D15 bis D0
in selektiertes Device
schreiben

Transfer quittieren:

DTACK~ -> low

Transferzyklus beenden:

DTACK~ low erkennen
Adressen freigeben
Adressmodifier freigeben
Datenleitungen freigeben
LWORD~ freigeben
IACK~ freigeben

DS1~ UND DS0~ -> high

AS~ -> low

Transferende:

DS1~ freigeben
DS0~ freigeben
AS~ freigeben

Transferende quittieren:

AS~ high erkennen
DS1~ high erkennen
DS0~ high erkennen

DTACK~ freigeben

Fig. 6